(19) Europäisches Patentamt
European Patent Office
Office européen des brevets

(11) Veröffentlichungsnummer: **0 151 372**
**B1**

(12) **EUROPÄISCHE PATENTSCHRIFT**

(45) Veröffentlichungstag der Patentschrift: **31.10.90**

(51) Int. Cl.$^5$: **G 03 F 7/16,** G 03 F 7/38

(21) Anmeldenummer: **84810658.9**

(22) Anmeldetag: **27.12.84**

# (54) Verfahren zur Bilderzeugung.

(30) Priorität: **03.02.84 GB 8402937**

(43) Veröffentlichungstag der Anmeldung:
**14.08.85 Patentblatt 85/33**

(45) Bekanntmachung des Hinweises auf die Patenterteilung:
**31.10.90 Patentblatt 90/44**

(84) Benannte Vertragsstaaten:
**BE CH DE FR GB IT LI NL SE**

(56) Entgegenhaltungen:
**FR-A-2 226 694**
**FR-A-2 495 025**
**US-A-4 289 798**
**US-A-4 291 118**
**US-A-4 389 433**

(73) Patentinhaber: **CIBA-GEIGY AG**
**Klybeckstrasse 141**
**CH-4002 Basel (CH)**

(72) Erfinder: **Irving, Edward, Dr.**
**41, Swaffham Road**
**Burwell, Cambridge CB5 0AN (GB)**
Erfinder: **Smith, Terence James**
**6A, Dickasons, Melbourn**
**Royston, Hertfordshire SG8 6EL (GB)**

**EP 0 151 372 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die vorliegende Erfindung betrifft ein Verfahren zur Bilderzeugung, indem man ein mit einem Polymerisationsmittel vorbehandeltes Sustrat mit einem polymerisierbaren Harz beschichtet und anschliessend mit aktinischem Licht bestrahlt.

Im allgemeinen erfolgt die Bilderzeugung mittels Photopolymerisation dadurch, dass man ein Substrat mit einer Lösung einer photopolymerisierbaren Substanz in einem flüchtigen organischen Lösungsmittel beschichtet, das Lösungsmittel verdampft oder verdampfen lässt, wobei ein Film der photopolymerisierbaren Substanz entsteht, diesen Film mit aktinischem Licht bestrahlt, z.B. durch ein Negative, wordurch die bestrählten Stellen des Films photopolymerisiert und damit weniger löslich werden, während die nicht bestrahlten Stellen im wesentlichen unverändert bleiben, und schliesslich die nicht betrahlten, nicht photopolymerisierten Stellen des Films mit einem geeigneten Lösungsmittel weglöst, das die bestrahlten photopolymerisierten stellen nicht löst. Diese letzte Stufe ist allgemein als 'Entwickeln" bekannt.

Es besteht ein Bedürfnis nach einem Verfahren, bei dem Substrate in Abwesenheit von organischen Lösungsmitteln mit photopolymerisierbarren Substanzen beschichtet und diese Beschichtung in einem im wesentlichen festen, nicht-klebrigen und für die Bestrahlung bereiten Zustand übergeführt werden können. Damit könnte in dieser Phase nicht nur auf die Verwendung von Lösungsmitteln, die Probleme der Entflammbarkeit und Rückgewinnungskosten verursachen können, verzichtet werden, sondern es würde auch die Herstellung von bescheichteten, für die Bestrahlung bereiten Substraten in einem kontinuierlichen Verfahren erleichtert.

Es wurde nun gefunden, dass dieses Ziel dadurch erreicht werden kann, dass man mit einem Polymerisationsmittel vorbehandelte Substrate mit bestimmten flüssigen Stoffgemischen mit Gruppen, welche die Polymerisation und die Vernetzung (Härtung) unter Lichteinfluss ermöglichen, beschichtet. Diese Gruppen können Bestandteil eines einzigen Moleküls sein oder sie können in verschiedenen Molekülen vorliegen. Die Gruppen werden so gewählt, dass sich Schichten aus flüssigen Stoffgemischen mittels Polymerisation schnell in feste, in wesentlichen klebfreie Schichten überführen lassen, die jedoch in bestimmten Lösungmitteln noch löslichen sind. Falls erwünscht, kann ein Teil oder können Teile der Schicht mit aktinischem Licht bestrahlt werden, wobei in der schon polymerisierten Schicht eine Vernetzung unter Lichteinfluss erfolgt. Dabei werden die Teile der Schicht, die sich unter Lichteinfluss härten bzw. vernetzen lassen, gegenüber dem Lösungsmittel bedeutend weniger löslich.

In der U.S. Patentschrift Nr. 4.291.118 wird ein Verfahren zum Erzeugen von Reliefabbildungen aus Filmen aus einem flüssigen photopolymerisierbaren Material beschrieben. Dabei wird der Film bis zur Verfestigung einer chemischen Härtung unterzogen, und der verfestigte Film wird in einem bestimmten vorgegebenen Muster so behandelt, dass in dem verfestigten Film entsprechend dem Muster an den behandelten und nicht behandelten Stellen unterschiedliche chemische Zustände entstehen. Anschliessend wird selektiv der Teil der Masse in dem einen chemischen Zustand entfernt, wobei der Teil der Masse in dem anderen chemischen Zustand ein Reliefbild bildet. Um die unterschiedlichen chemsichen Zustände zu erzeugen, wird in allen beschriebenen Ausführungsformen aktinisches Licht angewendet.

Bei dem in dieser U.S. Patentschrift beschriebenen Verfahren wird somit der Film aus flüssigem Material mit aktinischem Licht bestrahlt, und der verfestigte Film wird anschliessend erneut in einem vorgegebenen Muster mit aktinischem Licht bestraht, so dass sich ein Teil oder Teile des Films weniger leicht mit Lösungsmitteln entfernen lassen. Schliesslich wird das Bild entwickelt, indem man mit dem Lösungsmittel die leichter entfernbaren Teile, d.h. die nicht ein zweites Mal bestrahlten Teile, auswäscht. Die Bestrahlungsbedingungen müssen bei diesem Verfahren sehr genau eingehalten werden. Bei ungenügender Bestrahlung in der ersten Stufe bleibt das verfestigte Material klebrig und unangenehm in der Handhabung. Wird es zuviel bestrahlt, so erhält man Bilder mit ungenügender Auflösung. Es wird nur die Verwendung von photopolymerisierbaren Polyen-Polythiol-Stoffgemischen beschrieben. Diese haben bei dem in der U.S. Patentschrift beschriebenen Verfahren den Nachteil, dass die durch die Bestrahlung mit aktinischem Licht initiierte Polymerisation weitergeht, wenn die Bestrahlung unterbrochen wird. Daraus folgt, dass zum Erzielen Bilder guter Qualität die zweite Bestrahlung sofort vorgenommen werden muss. Dies beeinträchtigt die industrielle Anwendung dieses Verfarhens.

Methoden zum Vorbehandeln von Substraten, auf denen ein anschliessend appliziertes Harz polymerisiert wird, sind an sich bekannt. So wird z.B. in der U.S. Patentschrift Nr. 3.027.278 ein Verfahren zum Beschichten anorganischer Substrate beschrieben, bei dem zuerst eine ein Amin enthaltende wässrige Schicht appliziert und die oberfläche anschliessend mit Phenolformaldehyd-Dämpfen behandelt wird. Beim Erhitzen der Oberfläche polymerisieren die organischen Materialien.

Die U.S. Patentschrift Nr. 3.053.690 offenbart eine Beschichtungsmethode, bei der die Gegenstände zuerst mit einem phenolischen Harz grundiert und dann mit einem Gemisch aus Aethylacetat und konzentrierter Schwefelsäure gespritzt werden. Anschliessend lässt man das Lösungsmittel verdampfen und beschichtet mit einem Harz auf der Basis von Furfurylalkohol, wobei die restliche Säure das Härten des genannten Harzes bewirkt.

Nach dem in U.S. Patentschrift Nr. 3.196.035 beschriebenen Verfahren werden Polyesterfasern mit einem Polyisolcyanat beschichtet. Anschliessend werden die beschichteten Fasern mit einem Epoxidharz behandelt. Auch gemäss U.S. Patentschrift Nr. 3.523.032 werden Epoxidharz zum Beschichten von Fasern verwendet, wobei für die Verbehandlung ein Imidazol eingesetzt wird.

Nach dem Beschichtungsverfahren gemäss U.S. Patentschrift Nr. 3.218.190 wird ein Peroxid-Katalysator in einem Lösungsmittel appliziert. Das Lösungsmittel wird verdampft und schliesslich wird ein ungesättigter Polyester aufgetragen. Der Peroxid-Katalysator bewirkt die Härtung des Polyesters.

Die Verwendung von Wasser zur Vorbehandlung ist in der U.S. Patentschrift Nr. 3.493.418 beschrieben. Nach dieser Patentschrift wird zuerst ein wasserhaltiges filmbildendes Bindemittel auf ein Substrat aufgetragen, worauf man ein unter der Einwirkung von Feuchtigkeit härtbares Urethan-Präpolymer appliziert. Dabei migriert Wasser von der ersten in die zweite Schicht und bewirkt die Härtung.

Die U.S. Patentschrift Nr. 3.650.802 beschreibt die Verwendung von eisenhaltigen Materialien, wie Eisen(III)acetylacetonat, zum Beschichten von Substraten, die anschliessend mit einem Gemisch aus einem Polythiol, einem Polyen und gegebenenfalls einem Oximester beschichtet werden. Das Polythiol-Polyen-Gemisch wird anschliessend gehärtet.

Die Verwendung von Koffein und Theobromin als Polymerisationsinitiatoren ist aus der U.S. Patentschrift Nr. 4.042.442 bekannt. Gemäss dieser Patentschrift werden Öberflächen mit einer Lösung des Alkaloids in einem Lösungsmittel, wie Wasser, Aceton oder einem Alkohol, beschichtet, worauf ein monomerer Ester der 2-Cyanacrylsäure aufgetragen wird. Die Polymerisation dieses Esters erfolgt schnell.

Die U.S. Patentschrift Nr. 3.473.949 beschreibt ein Verfahren zum Herstellen von Acrylharz-Beschichtungen, wobei, N,N-Dimethyl-p-toluidin in einem Lösungsmittel als Grundierung auf ein Substrat aufgespritzt wird. Anschliessend werden ein Acrylmonomer mit Glycidylgruppen, wie Glycidylmethacrylat, und ein organisches Peroxid aufgetragen. Die äussere Beschichtung härtet innerhalb von etwa 10 Minuten; zur Vervollständigung der Härtung wird erhitzt.

Das Vorbehandeln von Substraten mit einem Härter für lichtempfindliche Schichten ist aus der U.S. Patentschrift Nr. 4.241.171 bekannt. Ein Trägermaterial wird mit einem Härter für Gelatine, besonders Bernsteinaldehyd, beschichtet, und dieser wird dann mit einer Trennschicht versehen. Anschliessend wird eine photographie Emulsion appliziert. Während des Trocknens diffundiert der Härter durch die Trennschicht und vernetzt die Gelatine in der photographischen Emulsion. Dabei erfolgt kein weiteres Aushärten der lichtempfindlichen Schicht. Durch Belichtung werden die lichtempfindlichen Elemente in dieser Schicht, nicht aber deren Gesamthärte beeinflusst. Beim Behandeln mit einem Entwickler werden die nicht belichteten Stellen der Schicht nicht entfernt. Es entsteht somit auch kein dreidimensionales Bild auf dem Trägermaterial.

Keine der oben erwähnten Patentschriften offenbart ein Verfahren, bei dem durch die anfängliche Polymerisation eine in bestimmten Lösungsmitteln noch lösliche Oberfläche gebildet und vollkständige Unlöslichkeit durch bestrahlung bewirkt werden, wodurch die Bilderzeugung ermöglicht wird.

Demgemäss betrifft die Erfindung ein Verfahren zur Bilderzeugung, indem man

a) auf ein Substrat ein Polymerisationsmittel aufträgt,

b) auf das Polymerisationsmittel auf dem Substrat eine Schicht aus einem flüssigen Stoffgemisch, das einen im Kontakt mit dem Polymerisationsmittel polymerisierbaren Rest und einen lichtvernetzbaren Rest enthält, derart appliziert, dass sich die Schicht verfestigt, aber noch lichtvernetzbar bleibt,

c) die verfestigte Schicht in einem vorgegebenen Muster derart mit aktinischem Licht bestrahlt, dass die bestrahlten Teile der Schicht vernetzt werden, und

d) die Teile der Schicht, welche unter der Einwirkung von Licht im wesentlichen nicht vernetzt wurden, durch Behandlung mit einem dafür geeigneten Lösungsmittel entfernt.

Der Ausdruck "in einem vorgegebenen Muster bestrahlt" umfasst sowohl das Bestrahlen durch ein ein Bild aufweisendes transparentes Material als auch das Bestrahlen mit einem computergesteuerten, ein Bild erzeugenden Laserstrahl.

Das in der Stufe b) des erfindungsgemässen Verfahrens auf ein Substrat applizierte flüssige Stoffgemisch kann Substanzen enthalten, welche die polymerisierbaren und lichtvernetzbaren Gruppen in demselben Molekül aufweisen, oder es kann ein Gemisch aus einem oder mehreren Materialien, die im Kontakt mit dem Polymerisationsmittel polymerisiert werden können, zusammen mit einem oder mehreren lichtvernetzbaren Materialien enthalten.

Die polymerisierbaren Reste können ihrerseits eine einzige Spezies oder zwei oder mehr ähnliche Spezies aufweisen, die unter der katalytischen Einwirkung des Polymerisationsmittels polymerisieren, oder sie können zwei oder mehr miteinander reagierende Spezies aufweisen, die vergleichsweise siabil sind, bis deren Reaktion untereinander durch das Polymerisationsmittel katalysiert oder beschleunigt wird.

Das Polymerisationsmittel ist eine Substanz, welche entweder die Polymerisation einer einzigen Spezies oder die Copolymerisation von zwei oder mehr ähnlichen Spezies initiiert oder katalysiert oder als Katalysator oder Beschleuniger für eine polymerbildende Reaktion zwischen zwei oder mehr Co-Reaktanden wirkt. Solche Materialien können neutral, basisch oder sauer sein, und deren Wahl hängt von der Natur des zu polymerisierenden Materials ab.

Geeignete polymerisierbare Reste und dafür einsetzbare Polymerisationsmittel sind z.B.: Cyanacrylate mit Wasser, wässriger Ammoniumhydroxidlösung, einer wässrigen Alkalimetallhydroxid-Lösung oder einem Amin; Gemische aus Polyolen und Isocyanaten mit wässriger Ammoniumhydroxidlösung, einer

wässrigen Alaklimetallhydroxid-Lösung oder einem Amin; Präpolymere mit Isocyanat-Endgruppen mit Wasser, wässriger Ammoniumhydroxidlösung, einer wässrigen Alkalimetallhydroxid-Lösung oder einem Amin; Polyen-Polythiol-Gemische mit wässriger Ammoniumhydroxid-Lösung, einer wässrigen Alkalimetallhydroxid-Lösung oder einem Amin; Epoxidharze mit einem Bortrifluorid- oder Bortrichlorid-Komplex, einem Bordifluoridchelat, Dicyandiamid, einem Imidazol, einem Amin oder einem Säureanhydrid; Epoxidharz-Amin-Gemische mit einer Säure, einer wässrigen sauren Lösung, einer Lösung eines sauren Salzes, oder mit einem Metallperchlorat, Trifluormethansulfonat, Trihalogencarboxylat oder Nitrat, die als Beschleuniger für Epoxidharz/Amin-Reaktionen bekannt sind; Epoxidharz-Thiol-Gemische mit wässriger Ammoniumhydroxidlösung oder einem Amin; phenolische Harze mit einer Säure oder einer wässrigen sauren Lösung, sowie Gemische aus einem Acrylat oder Methacrylat und einem Peroxidinitiator zusammen mit einem Beschleuniger für das Peroxid, wie Amine, Schiff-Basen, Uebergangsmetalle oder Salze davon.

Bei Verwendung von Polymerisationsmitteln, die nur beim Erhitzen die Polymerisation der polymerisierbaren Reste bewirken, wird das Substrat nach dem Auftragen des flüssigen Stoffgemisches erhitzt.

Beispiele von bevorzugten Aminen, die als Polymerisationsmittel eingesetzt werden können, sind: Trimethylamin, Diäthylamin, Triäthylamin, Propylamine, Butylamine, Octylamine, N,N-Dimethyloctylamine, Isophorondiamin, aromatische Amine, wie Phenylendiamine.

Als Schiff-Basen eingnen sich z.B. Umsetzungsprodukte aus aliphatischen Diaminen oder Polyaminen und aliphatischen Aldehyden oder Ketonen, wie die Umsetzungsprodukte aus Aethylendiamin, Diäthylentriamin oder Triäthylentetramin und Acetaldehyd, Aceton oder Methylisobutylketon. Als Säuren und saure Lösungen eignen sich z.B. Chlorwasserstoffsäure, Schwefelsäure, p-Toluolsulfonsäure, Methansulfonsäure und Sulfaminsäure. Geeignete Metallpherchlorate, Trifluormethansulfonate, Trihalogencarboxylate und Nitrate sind in den U.S. Patentschriften Nr. 4.026.858, 4.101.459, 4.115.296 und 4.130.511 beschrieben.

Geeignete Bortrichloridkomplexe sind z.B. Komplexe mit tertiären Aminen, wie Trimethylamin, Octyldimethylamin und weiteren Aminen der in der U.S. Patentschrift Nr. 3.784.647 beschriebenen Art. Als Bortrifluoridkomplexe können beispielsweise Komplexe mit einem Triarylphosphin, mit Piperidin oder mit einem primären Amin, besonders Triphenylphosphin, Isophorondiamin, Aethylamin, Benzylamin, Cyclohexylamin und Tetramethylhexamethylendiamin, eingesetzt werden. Als Beispiele von geeigneten Bordifluoridchelaten seien Difluorbor-2-hydroxyacetophenon, Difluoroboracetoacetanilid und weitere Chelate, wie sie in der U.S. Patentschrift Nr. 3.424.699 beschrieben sind, genannt. Als Imidazole können z.B. 2-Methylimidazol, 2-Phenylimidazol, 1-Benzyl-2-methylimidazol und 1-Cyanoäthyl-2-methylimidazol verwendet werden. Als Uebergangsmetalle und Salze davon eignen sich z.B. Kobalt, Nickel und Eisen in kolloidaler Form oder als in organischen Lösungsmitteln lösliche Salze mit organsichen Säuren wie die Naphthenate, Octanoate und Laurate.

Als Cyanacrylate, die im erfindungsgemässen Verfahren eingesetzt werden können, eignen sich z.B. Verbindungen der Formel I

$$H_2C{=}\underset{\displaystyle CN}{\underset{|}{C}}{-}COOR^1 \qquad (I),$$

worin $R^1$ höchstens 18 C-Atome aufweist und eine Alkyl-, Alkenyl-, Aralkyl-, Halogenalkyl-, Cycloalkyl-, Aryl- oder Alkoxyalkylgruppe, besonders eine Methyl-, Aethyl-, Allyl-, Benzyl-, Chlormethyl-, Cyclohexyl-, Phenyl- oder Aethoxyäthylgruppe, ist.

Als Gemische aus Polyolen und Isocyanaten können z.B. Gemische aus Diolen, beispielsweise Alkylenglykolen, wie Aethylenglykol, 1,4-Butandiol und Bis(hydroxymethyl)cyclohexan, und Polyoxyalkylenglykolen, wie Polyoxyäthylen- und Polyoxypropylenglykolen mit Molekulargewichten von 200 bis 5000, Triolen, wie Glycerin, anderen Alkantriolen und Polyoxyäthylen- und Polyoxypropylentriolen mit Molekulargewichten von 400 bis 4000, hydroxylgruppenhaltigen Reaktionsprodukten aus Epoxidharzen mit einem Material mit Gruppen, die mit Epoxidgruppen zu reagieren vermögen, wie Carbonsäure-, Carbonsäureanhydrid-, phenolische Hydroxyl-, primäre oder sekundäre Amino- und Thiolgruppen, Pentaerythrit und hydroxylgruppenhaltigen Polymeren, wie polymeren von Hydroxylalkylacrylaten und -methacrylaten und Copolymeren aus Styrol und Allylalkohol, und aliphatischen, cycloaliphatischen und aromatischen Isocyanaten erwähnt werden. Geeignete Isocyanate sind z.B. Hexamethylendiisocyanat, Phenylendiisocyanat, Toluylendiisocyanat, Diphenylmethandiisocyanat, Dicyclohexylmethandiisocyanat, Naphthylendiisocyanate und Präpolymere mit loscyanat-Endgruppen, die durch Umsetzung eines Polyols, Polyamins oder einer Polycarbonsäure und solchen Diisocyanaten erhalten werden. Geeignete Addukte mit Isocyanatgruppen sind z.B. in der U.S. Patentschrift Nr. 4.173.682 beschrieben. Solche Präpolymere mit Isocyanat-Endgruppen können auch ohne Zusatz eines Polyols mit Ammoniak oder Aminen polymerisiert werden, wie es z.B. in der britischen Patentanmeldung Nr. 2.093.049 beschrieben ist.

Als Polyen-Polythiol-Gemische können z.B. solche der in der britischen Patentschrift Nr. 1.293.722 beschriebenen Art verwendet werden. Die Polyene weisen im allgemeinen ein Molekulargewicht von 50 bis 2000 auf und enthalten zwei oder mehr äthylenische oder äthynylische, zur Polymerisation in Gegenwart von freien Radikalbildnern befähigte Bindungen. Bevorzugt als Polyene sind u.a. Reaktionsprodukte aus 1 Mol Toluylendiisocyanat und 2 Mol eines Dialkenyläthers von Trimethylolpropan, Reaktionsprodukte aus 1 Mol eines polymeren Diisocyanats mit 2 Mol Allylalkohol, Reaktionsprodukte aus 1 Mol Polyäthylenglykol mit 2 Mol Toluylen-2,4-diisocyanat und 2 Mol Allylakohol, Polyisopren, Polybutadien und andere ungesättigte Polymere, bei denen sich die ungesättigte Bindung vornehmlich in der Hauptkette befindet, Verbindungen mit reaktiven ungesättigten C-C-Bindungen in Konjugation mit benachbarten ungesättigten Gruppierungen, wie Polyäthylenätherglykolidiacrylat mit einem Molekulargewicht von etwa 750, Polytetramethylenätherglykoldimethacrylat mit einem Molekulargewicht von etwa 1175, das Triacrylat des Reaktionsproduktes aus Trimethylolpropan mit 20 Mol Aethylenoxid, sowie Reaktionsprodukte aus Polyepoxiden mit Aminen, Alkoholen, Thialkoholen oder Säuren mit aliphatisch ungesättigten Bindungen, wie z.B. die Reaktionsprodukte von Bisphenol-A-Diglycidyläther mit Allylamin oder Diallylamin.

Geeignete Polythiole weisen im allgemeinen ein Molekulargewicht von 50—20000, besonders 100—10000 auf. Ester der Thioglykol-, α-Mercaptopropion- und β-Mercaptopropionsäure mit Glykolen, Triolen, Tetraolen, Pentaolen oder Hexolen sind bevorzugt. Als spezifische Beispiele bevorzugter Polythiole seien erwähnt: Aethylenglykolbis(thioglykolat), Aethylenglykol-bis(β-mercaptopropionat), Trimethylpropan-tris(β-mercaptopropionat), Pentaerythrit-tetrakis(β-mercaptopropionat) und Tris(hydroxyäthyl)isocyanurat-tris(β-mercaptopropionat). Geeignete Polyen-Polythiol-Gemische sind ferner in der britischen Patentschrift Nr. 1.293.722 beschrieben.

Als Epoxidharze verwendet man im erfindungsgemässen Verfahren bevorzugt solche, die mindestens zwei direkt an ein O—, N— oder S-Atom gebundene Gruppen der Formel II

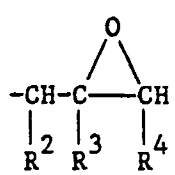

(II)

aufweisen, worin entweder $R^2$ und $R^4$ je ein Wasserstoffatom und $R^3$ ein Wasserstoffatom oder eine Methylgruppe bedeuten oder $R^2$ und $R^4$ zusammen $—CH_2CH_2—$ und $R^3$ ein Wasserstoffatom darstellen.

Als Beispiele solcher Harze seien erwähnt: Polyglycidyl- und Poly(β-methylglycidyl)ester von aliphatischen und aromatischen Polycarbonsäuren, Polyglycidyl- und Poly(β-methylglycidyl)äther von Verbindungen mit mindestens zwei freien alkoholischen oder phenolischen Hydroxylgruppen. Es können auch Poly(N-glycidyl)derivate von Aminen und Poly(S-glycidyl)verbindungen verwendet werden. Spezifische bevorzugte Epoxidharze sind Polyglcyidyläther von 2,2-Bis(4-hydroxyphenyl)propan, Bis(4-hydroxyphenyl)methan oder Novolake aus Formaldehyde und Phenol, oder Phenolen, die im Ring durch ein Chloratom oder eine Alkylgruppe mit 1—9 C-Atomen substituiert sind, mit einem Epoxidgehalt von mindestens 0,5 Aequivalent/kg, Bis(4-diglycidylaminophenyl)methan und p-(Diglycidylamino)phenylglycidyläther.

Es können auch Epoxidharze verwendet werden, in denen einige oder alle Epoxidgruppen nicht endständig sind, besonders cycloaliphatische Epoxidharze, wie z.B. Vinylcyclohexendioxid, Limonendioxid, Dicyclopentadiendioxid, 4-Oxatetracyclo[6.2.1.0.$^{2,7}$.0.$^{3,5}$]undec-9-yl-glycidyläther, 1,2-Bis(4-oxatetracyclo[6.2.1.0.$^{2,7}$.0.$^{3,5}$]undec-9-yloxy)äthan, 3,4-Epoxycyclohexylmethyl-3',4'-epoxycyclohexancarboxylat und dessen 6,6'-Dimethylderivat, Aethylenglkyol-bis(3,4-epoxycyclohexancarboxylat), 3-(3,4-Epoxycyclohexyl)-8,9-epoxy-2,4-dioxaspiro[5.5]undecan sowie epoxidierte Butadiene oder Copolymere von Butadienen mit äthylenischen Verbindungen, wie Styrol und Vinylacetat.

Epoxidharz/Thiol-Mischungen, die im erfindungsgemässen Verfahren eingesetzt weden können, sind bevorzugt Gemische aus den oben beschriebenen Epoxidharzen und Polythiolen. Geeignete Amine zur Verwendung in Epoxidharz/Amin-Gemsichen können primär, sekundär oder tertiär und aliphatisch, alicyclisch, ungesättigt heterocyclisch, aromatisch oder araliphatisch sein, z.B. N,N,N',N'-Tetramethyläthylen-, -propylen-oder -butylen-diamine, Trialkylmonoamine, wie Triäthylamin, Trialkanolamine, wie Triäthanlamin, N,N'-Dimethylpiperazin, Triäthylendiamin, Hexamethylentetramin, Pyridin, Chinolin, Benzyldimethylamin, 2,4,6-Tris(dimethylaminomethyl)phenol, und aromatische Diamine, wie 4,4'-Diaminodiphenylmethan, 3-Aethyl-4,4'-diaminodiphenylmethan und 3,3'-Diäthyl-4,4'-diaminodiphenylmethan.

Als phenolische Harze können im erfindungsgemässen Verfahren z.B. Resole aus Phenolen, besonders Phenol selbst, und einem Alkdehyd, im allgemeinen Formaldehyd, verwendet werden.

Beispiele von Acrylat- und Methacrylat-Monomeren, die mit dem Beschleuniger für die peroxidinitiierte Polymerisation gemischt und im Kontakt mit einem freie Radikale bildenden Peroxid-Initiator polymerisiert werden können, sind Acryl- und methacrylsäure Alkylacrylate, wie Methyl- und Aethylacrylat, Alkylendioldiacrylate, wie Aethylen- und Propylenglykoldiacrylate, 1,1,1-Trimethylolpropantriacrylat,

Polypropylenkoldiacrylate, Allylacrylat, Acrylatester von Epoxiden oder phenolischen Resolen, sowie die entsprechenden Methacrylate. Geeignete Peroxid-Initiatoren sind z.B. Wasserstoffperoxid, tert-Butylhydroperoxid, Cumolhydroperoxid und 2,4-Dimethyl-2,4-hexandihydroperoxid.

Als lichtvernetzbare Reste kommen sowohl solche in Betracht, bei denen die Vernetzung durch direkte Aktivierung der lichtempfindlichen Gruppen mittels Bestrahlung erfolgt, als auch solche, bei welchen durch die Bestrahlung ein geeignetes Initiatormolekül angeregt wird, welches dann die photopolymerisierbaren Gruppen aktiviert.

Materialien mit lichtempfindlichen Gruppen sind bekannt und umfassen z.B. solche mit mindestens zwei, bevorzugt 3 oder mehr Gruppen ausgewählt aus Azido-, Cumarin-, Stilben-, Maleinimid-, Pyridinon-, Chalkon-, Propenon-, Pentadienon-, Anthracen- und Acrylsäureester- gruppen, die in der 3-Stellung durch eine äthylenisch ungesättigte Gruppe oder eine aromatische Gruppe in Konjugation mit der äthylenischen Doppelbindung der Acrylgruppe substituiert sind.

Als Materialien, bei denen die Photovernetzung durch Aktivierung eines Photoinitiators erfolgt, der dann seinerseits polymerisierbare Gruppen aktiviert, können z.B. verwendet werden: Epoxidharze, phenolische Harze, Harnstoff-Formaldehyd-Harze, cyclische Aether, cyclische Ester, cyclische Sulfide, cyclische Amine und cyclische Organosiliziumverbindungen in Kombination mit einem strahlungsempfindlichen aromatischen Oniumsalz, wie z.B. Diazonium-, Sulfonium-, Jodonium- und Sulfoxoniumsalze, oder einem strahlungsempfindlichen aromatischen Jodosylsalz, sowie Ester und Teilester von Acryl- oder Methacrylsäure mit einwertigen aliphatischen Alkoholen, Glykolen und höherwertigen Polyolen, oder mit Verbindungen, die eine oder mehr Glycidylgruppen enthalten, ferner Ester, erhalten durch Reaktion eines Polyepoxids mit einem Addukt aus einem Hydroxylakylacrylat oder -methacrylat und einem gesättigten oder ungesättigten Polycarbonsäureanhydrid.

Beispiele von geeigneten Aziden sind solche mit mindestens zwei Gruppen der Formel III

$$N_3R^5\text{—} \qquad \text{(III)},$$

worin $R^5$ einen einkernigen oder zweikernigen zweiwertigen aromatischen Rest mit insgesamt 6 und höchstens 14 C-Atomen, besonders eine Phenylen- oder Naphthylengruppe, bedeutet.

Beispiele von geeigneten Cumarinen sind solche mit Gruppen der Formel IV

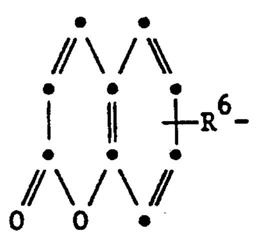

(IV),

worin $R^6$ —O—, —COO—, —$SO_2$— oder —$SO_2O$— darstellt.

Als Stilbene eignen sich z.B. solche mit Gruppen der Formel V

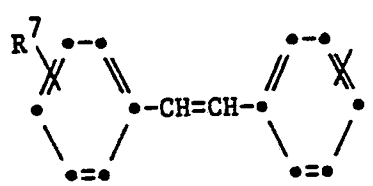

(V),

worin $R^7$ der insgesamt bis zu 8 C-Atome enthaltende Rest eines 5- oder 6-gliedrigen N-haltigen heterocyclischen Ringes ist, der mit einem Benzol- oder Naphthalinkern kondensiert und über ein zu einem Ring-N-Atomen benachbartes C-Atom des heterocyclishen Ringes an den genannten Benzolkern gebunden ist, wie z.B. Benzimidazolyl-, Benzoxazolyl-, Benztriazolyl-, Benzthiazolyl- oder Naphthotriazolylreste.

Beispiele von Verbindungen mit Maleinimidgruppen sind solche mit Gruppen der Formel VI

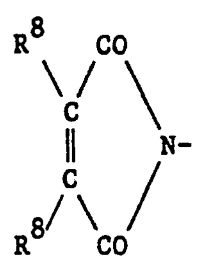

(VI),

worin die $R^8$ Alkyl mit 1—4 C-Atomen, ein Chloratom oder eine Phenylgruppe und besonders eine Methylgruppe bedeuten.

Als Verbindungen mit Pyridinongruppen eignen sich z.B. solche mit Gruppen der Formel VII

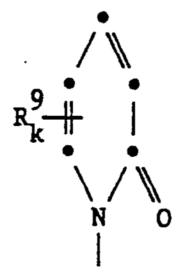

(VII),

worin $R^9$ einen aliphatischen oder cycloaliphatischen Rest mit bis zu 8 C-Atomen und k 0 oder eine ganze Zahl von 1—4 bedeuten.

Als Verbindungen mit Chalkon-, Propenon- und Pentadienongruppen kommen solche mit Gruppen der Formel VIII oder IX

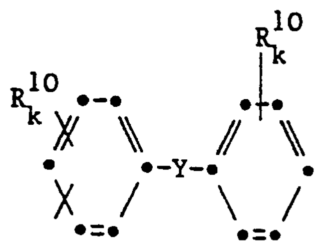

(VIII)

oder

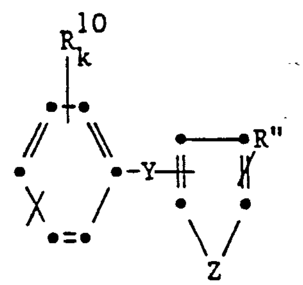

(IX)

in Betracht, worin der $R^{10}$ ein Halogenatom, eine Alkyl-, Cycyloalkyl-, Alkenyl-, Cycloalkenyl-, Alkoxy-, Cycloalkoxy-, Alkenyloxy-, Cycloalkenyloxy-, Alkoxycarbonyl-, Cycloalkoxycarbonyl-, Alkenyloxycarbonyl- oder Cycloalkenyloxycarbonylgruppe mit je bis zu 9 C-Atomen, eine Nitrogruppe, eine Carbonsäure-, Sulfonsäure- oder Phosphorsäuregruppe in Salzform bedeuten,

k die oben angegebene Bedeutung hat,

$R^{11}$ eine Bildung oder ein Wasserstoffatom,

Y eine Gruppe der Formel X, XI oder XII

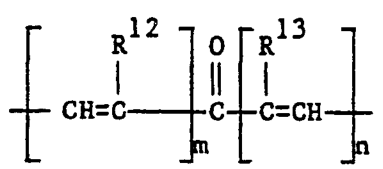

(X),

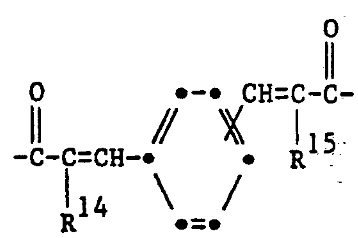

(XI)

oder

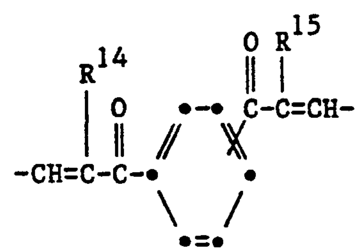

(XII),

$R^{12}$ und $R^{13}$ unabhängig voneinander ein Wasserstoffatom, eine Alkylgruppe mit z.B. 1—4 C-Atomen oder eine Arylgruppe, besonders eine einkernige Arylgruppe, wie die Phenylgruppe, oder $R^{12}$ und $R^{13}$ zusammen eine Polymethylenkette mit 2—4 Methylengruppen,

$R^{14}$ und $R^{15}$ unabhängig voneinander ein Wasserstoffatom, eine Alkylgruppe mit z.B. 1—4 C-Atomen oder eine Arylgruppe, vorzugsweise eine einkernige Gruppe, wie die Phenylgruppe,

m und n unabhängig voneinander Null, 1 oder 2, aber nicht beide Null, und

Z eine Sauerstoff- oder Schwefelatom bedeuten.

Geeignete Anthracene sind solche mit Anthrylgruppen, wie die 1-, 2- oder 9-Anthrylgruppe, die unsubstituiert oder durch ein oder zwei Brom- oder Chloratome, eine oder zwei Methyl- Nitrogruppen substituiert sein können.

Als 3-substituierte Acrylate eignen sich z.B. solche der Formel XIII

$$R^{16}—CH=C(R^{17})COO— \qquad (XIII),$$

worin $R^{16}$ eine aliphatische oder einkernige aromatische, araliphatische oder heterocyclische Gruppe darstellt, die — wie schon erwähnt — äthylenisch ungesättigt ist oder in Konjugation mit der äthlenischen Doppelbindung aromatischen Charakter hat, wie z.B. die Phenyl-, 2-Furyl-, 2- oder 3-Pyridyl-, Prop-2-enyl- oder Styryl- gruppe, und

$R^{17}$ ein Wasserstoff-, Chlor- oder Bromatom oder eine Alkylgruppe mit 1—4 C-Atomen darstellt.

Als Beispiele solcher Verbindungen seien die Disorbinsäureester von Poly(oxyalkylen)glykolen, Polyvinylzimtsäureester und Reaktionsprodukte aus Epoxidharzen und Zimtsäure genannt.

Oniumsalze, die in Kombination mit Epoxidharzen oder anderen kationisch polymerisierbaren Substanzen photopolymerisierbare Mischungen ergeben, sind in den U.S. Patentschriften Nr. 4.058.400 und 4.058.401 beschrieben. Sulfoxoiumsalze, die für denselben Zweck eingesetzt werden können, sind in den U.S. Patentschriften Nr. 4.299.938, 4.339.567 und 4.383.025 beschrieben. Es können auch Monoaryl-Jodoniumsalze verwendet werden.

Aromatische Jodosylsalze, die in Kombination mit kationisch polymerisierbaren Substanzen photopolymerisierbare Gemische ergeben, sind z.B. solche der Formel

$$[(Ar^1)(Ar^2)I1O]_tX^{t-},$$

worin

$Ar^1$ und $Ar^2$ unabhängig voneinander einen einwertigen aromatischen Rest mit 4—25 C-Atomen,

$X^{t-}$ ein t-wertiges Anion einer Protonesäure und

t 1, 2 oder 3 bedeuten.

$Ar^1$ und $Ar^2$ sind vorzugsweise je Phenyl, wobei die Phenylringe durch eine Alkylgruppe mit 1—4 C-Atomen, ein Halogenatom oder eine Nitrogruppe substituiert sein können.

Die Anionen $X^{t-}$ werden so gewählt, dass eine wirksame Vernetzung eintritt. Aufeinander abgestimmte kationisch polymerisierbare Materialien und geeignete Anionen können vom Fachmann auf dem Gebiet der Vernetzung oder Polymerisation kationisch polymerisierbarer Stoffgemische leicht ermittelt werden. Salze mit Anionen, die sich von organischen Carbonsäuren, organischen Sulfonsäuren und anorganischen Säuren ableiten, besonders Acetate, Trifluoracetate, Methansulfonate, Benzolsulfonate, p-Toluolsulfonate, Trifluormethansulfonate, Fluoride, Chloride, Bromide, Jodate, Perchlorate, Nitrate, Sulfate, Hydrogensulfate, Phosphate oder Hydrogenphosphate eignen sich z.B. zum Vernetzen von Phenoplasten, wie Phenol-Formaldehydharzen, und Aminoplasten, wie Harnstoff-Formaldehydharzen. Salze mit einem Pentafluorhydroxoantimonat-Anion oder einem Metallhalogenid- oder Metalloidhalogenid-Anion der Formel $MQ_w^-$, worin

M das Atom eines Metalls oder Metalloids,

Q ein Halogenatom und

w eine ganze Zahl von 4 bis 6 bedeuten, wobei w um eines grösser ist als die Wertigkeit, von M, eignen sich zum Vernetzen von Epoxidharzen und Episulfidharzen.

Bevorzugte Anionen $MQ_w^-$ sind das Hexafluorantimonat-, Hexachlorantimonat-, Hexafluorarsenat-, Tetrachlorferrat-, Hexachlorstannat-, Tetrafluorborat- oder Hexafluorphosphat-Anion, wobei die beiden letztgenannten besonders bevorzugt sind.

Die Jodosylsalze können analog den von F. M. Beringer und P. Bodländer [J. Org. Chem. 1968, *33*, 2981-4] beschriebenen oder ähnlichen Verfahren hergestellt werden.

Als Ester oder Teilester von Acryl- und Methacrylsäure, die als lichtvernetzbare Reste im erfindungsgemässen Verfahren verwendet werden können, kommen z.B. solche mit mindestens einer Gruppe der Formel XIV

$$H_2C=\underset{\displaystyle R^{18}}{\underset{|}{C}}-COO- \qquad (XIV)$$

in Betracht, worin $R^{18}$ ein Wasserstoffatom oder eine Methylgruppe darstellt.

Bevorzugt sind Ester von Glykolen, wie Aethylenglykol, Triäthylenglykol und Tetraäthylenglykol, und Ester, die durch Umsetzung von Acryl- oder Methacrylsäure mit Mono- oder Polyglycidyläthern von ein- oder mehrwertigen Alkoholen oder Phenolen oder einem N-Glycidylhydantoin erhalten werden. Weitere geeignete Ester sind Umsetzungsprodukte aus einem Addukt eines Hydroxyalkylacrylats oder -methacrylats und einem Anhydrid, besonders Bernsteinsäure-, Maleinsäure- oder Phthalsäureanhydrid, und einem Epoxidharz.

Typische Beispiele Ester sind: 1,4-Bis(2-hydroxy-3-acryloyloxypropoxy)butan, Poly(2-hydroxy-3-acryloyloxypropyl)äther von Phenol-Formaldehydnovolaken, 2,2-Bis[(4-(2-hydroxy-3-(2-acryloyloxyäthoxy)-succinyloxypropoxy)]-phenyl)propan, 1-(2-Hydroxy-3-acryloyloxypropoxy)butan, -octan und -decan, Bis(2-hydroxy-3-acryloyloxypropyl)adipat, 2-Hydroxy-3-acryloyloxypropyl-propionat und 3-Phenoxy-2-hydroxypropyl-acrylat sowie die entsprechenden Methacrylate.

Wie oben erwähnt, können die polymerisierbaren Gruppen und die lichtvernetzbaren Gruppen in demselben Molekül vorliegen. So können z.B. Epoxidharze oder phenolische Resole mit photohärtbaren Gruppen in den oben beschriebenen Ausführungsformen, die den Einsatz von Epoxiden oder phenolischen Resolen vorsehen, verwendet werden; hydroxyl-substituierte Verbindungen mit photohärtbaren Gruppen eignen sich für Ausführungsformen, bei denen ein Gemisch aus einem Polyol und einem Isocyanat verwendet wird. In bestimmten Fällen, z.B. bei Verwendung von Materialien mit Epoxid-, Acrylat- oder Methacrylatgruppen, kann dieselbe Gruppe sowohl polymerisierbare als auch lichtvernetzbare Reste aufweisen, wobei die in der Verfahrensstufe b) erhaltene verfestigte Schicht genügend unvernetztes Material enthält, um in der Verfahrensstufe c) unter Lichteinfluss bildmässig vernetzt zu werden. Geeignete doppelfunktionelle Substanzen können hergestellt werden, indem man eine oder mehrere äthylenisch ungesättigte Gruppen, wie Acrylsäure-, Methacrylsäure- oder Zimtsäureestergruppen oder Chalkongruppen, in eine Verbindung mit einer oder mehreren polymerisierbaren Gruppen, wie Epoxidgruppen, oder einer oder mehreren Gruppen, die mit einer anderen reaktiven Gruppen auf einem anderen Molekül zu einem Polymer reagieren, wie, Mercapto- und Hydroxylgruppen, einführt. Die Einführung von äthylenisch ungesättigten Gruppen kann mittels Esterbildung erfolgen, z.B. unter Verwendung von Acryl-, Methacrylsäure- oder Zimtsäuregruppen oder Chalkongruppen enthaltenden Carbonsäuren und einer OH- oder SH-Gruppen enthaltenden Verbindung oder einem Epoxid in derartigen Verhältnissen, dass das Produkt mindestens eine nicht reagierte OH—, Mercapto- oder Epoxidgruppe enthält.

Werden Acrylsäure, Methacrylsäure oder Zimtsäure mit Epoxidharzen umgesetzt, so können alle Epoxidgruppen des Harzes umgesetzt werden, wobei die bei der Oeffnung des Epoxidringes entstehenden OH-Gruppen die für das erfindungsgemässe Verfahren erforderliche reaktive OH-Funktionalität liefern.

Weitere geeigneter doppelfunktionelle Substanzen sind z.B. hydroxy-substituierte Chalkone, hydroxyphenyl-substituierte Propenone und Pentadienone, hydroxy-substituierte Maleinimide und hydroxy-substituierte Pyridinone. Besonders bevorzugte doppelfunktionelle Substanzen sind mit Epoxidgruppen substituierte Chalkone, Propenone und Pentadienone, besonders Glycidyläther von chalkon-, propenon- oder pentadienon-gruppenhaltigen Phenolen, oder Umsetzungsprodukte von derartige Gruppen enthaltenden Bisphenolen mit einem Epoxidharz; Glycidylacrylat, Glycidylmethacrylat, Acrylat-, Methacrylat- oder Zimtsäureestergruppen enthaltende Aether und Ester von phenolischen Resolen und Epoxiden, einschliesslich voll umgesetzter Produkte aus Acrylsäure, Methacrylsäure und Zimtsäure und Epoxidharzen, wie, Polyglycidyläther von mehrwertigen Alkoholen und Phenol, sowie teilweise Reaktionsprodukte aus diesen Komponenten, wie 2 - (4 - Glycidyloxyphenyl) - 2 - (4 - (3 - acryloyloxy - 2 - hydroxypropoxy)phenyl)propan, 2 - (4 - Glycidyloxyphenyl) - 2 - [4 - (2 - hydroxy - 3 - methacryloyloxy)propoxy)phenyl]propan, 1 - Glycidyloxy - 4 - (3 - acryloyloxy - 2 - hydroxypropyloxy)-butan und 1 - Glycidyloxy - 4 - (2 - hydroxy - 3 - methacryloyloxypropyloxy)butan.

Einige der zur Verwendung in den flüssigen Stoffgemischen vorgeschlagenen Materialien können fest sein. Nötigenfalls können zur Herstellung flüssiger Stoffgemische mit geeigneter Viskosität nach an sich bekannten Verfahren nicht-flüchtige Verdünnungsmittel zugesetzt werden. So können z.B. be Verwendung von festen Acrylaten zur Erzielung von flüssigen Stoffgemischen mit der gewünschten Viskosität niedermolekulare flüssige Acrylate, wie Hydroxyalkylacrylate oder Nieder-Alkylendiolacrylate beigemischt werden.

Gemäss einer besonders bevorzugten Ausführungsform des erfindungsgemässen Verfahrens werden die folgenden polymerisierbaren Reste und Polymerisationsmittel dafür verwendet:

Cyanacrylate der Formel I, worin $R^1$ eine Alkylgruppe mit 1—8 C-Atomen darstellt, zusammen mit Wasser;

Gemische aus einem doppelfunktionellen, hydroxylgruppenhaltigen Reaktionsprodukt aus einem Epoxidharz und Acrylsäure oder Methacrylsäure une einem Diisocyanat zusammen mit einem aromatischen primären Amin;

Epoxidharze mit mindestens zwei Gruppen der Formel II zusammen mit einem Bordifluoridchelat;

Gemische aus einem Epoxidharz mit mindestens zwei Gruppen der Formel II und einem aromatischen primären Diamin zusammen mit einem Metallnitrat-Beschleuniger,

doppelfunktionelle Reaktionsprodukte aus Acrylsäure oder Methacrylsäure und einem phenolischen Resol aus Phenol und Formaldehyd zusammen mit einer Säure;

Gemische aus einem Peroxid-Initiator und einem Acrylat oder Methacrylat eines Alkylendiols oder des

Trimethylolpropans, einem Hydroxyalkylacrylat oder -methacrylat oder einem Reaktionsprodukt aus Acrylsäure oder Methacrylsäure und einem Polyglycidyläther eines mehrwertigen Alkohols oder Phenols zusammen mit einem Uebergangsmetallsalz-Beschleuniger, oder

Gemische aus einem Peroxid-Initiator und einem doppelfunktionellen Reaktionsprodukt aus Acrylsäure und Methyacrylsäure und einem phenolischen Resol aus Phenol und Formaldehyd zusammen mit einem Uebergangsmetallsalz-Beschleuniger.

Als lichtvernetzbare Reste werden insbesondere bevorzugt:

Epoxidharze erhalten durch Vorverlängerung eines eine Pentadienongruppe enthaltenden Bisphenol-Diglycidyläthers mite einem Bisphenol;

cycloaliphatische Epoxidharze in Kombination mit einem strahlungsempfindlichen aromatischen Oniumsalz;

Methylolgruppen in einem doppelfunktionellen Reaktionsprodukt aus Acrylsäure oder Methacrylsäure und einem Phenol-Formaldehyd-Resol in Kombination mit einem strahlungsempfindlichen aromatischen Oniumsalz;

Acrylat- oder Methacrylat-Gruppen in einem doppelfunktionellen Reaktionsprodukt aus Acrylsäure oder Methacrylsäure und einem Phenol-Formaldehyd-Resol;

Acrylate oder Methacrylate eines Alkylendiols oder des 1,1,1-Trimethylolpropans, oder Reaktionsprodukte aus Acrylsäure oder Methacrylsäure und einem Polyglycidyläther eines mehrwertigen Alkohols oder Phenols.

Um mit dem neuen Verfahren möglichst gute Bilder zu erzeugen, werden die Polymerisation und die Lichtvernetzung bevorzugt mit verschiedenen chemischen Vorgängen bewirkt. Wird zum Beispiel die erste Stufe durch Kontakt zwischen einem phenolischen Harz und einer Säure durchgeführt, so sollte in der zweiten Stufe vorzugsweise keine Umsetzung eines phenolischen Harzes mit einer infolge der Bestrahlung eines Initiatormoleküls freigesetzten Säure erfolgen.

Die Art und Weise, wied das Polymerisationsmittel appliziert wird, ist nicht kritisch. Im allgemeinen wird das Polymerisationsmittel durch Sprühen, Tauchen, Bürsten, Schleuderbeschichtung oder andere bekannte Beschichtungsmethoden aufgetragen, wobei die Applikation — sofern das Polymerisationsmittel nicht flüssig ist — aus einer Lösung oder Suspension in Wasser oder einem organischen Lösungsmittel erfolgt.

Die Lichtvernetzung kann mittels Bestrahlung in Gegenwart eines geeigneten Katalysators durchgeführt werden. Wie die lichtvernetzbaren Verbindungen, gehören die Katalysatoren zwei Hauptklassen an:

(i) solche, die bei Bestrahlung einen angeregten Zustand ergeben, der zur Bildung freier Radikale führt, die ihrerseits die Vernetzung des Monomeren initiieren (Photoinitiatoren) und

(ii) solche, die bei Bestrahlung einen angeregten Zustand ergeben, der seine Anregungsenergie auf ein Monomermolekül überträgt, wobei ein angeregtes Monomermolekül entsteht, das dann mit einem nicht angeregten Monomermolekül vernetzt (Photosensibilisatoren).

Zu der ersten Klasse gehören organische Peroxide und Hydroperoxide, α-halogen-substituierte Acetophenone, Benzoin und dessen Alkyläther, α-Methylbenzoin, Benzophenone, O-Alkoxycarbonyl-Derivate eines Benziloxims oder eines 1-Phenylpropan-1,2-dionoxims, Benzilketale, z.B. das Benzildimethylketal, substituierte Thioxanthone, z.B. 2-Chlorthioxanthon und 2-Isopropylthioxanthon, Anthrachinone und Gemische aus Phenothiazin-Farbstoffen oder Chinoxalinen mit Elektronendonoren. Diese Initiatoren werden für ungesättigte Ester, vor allem Acrylate und Methacrylate, angewendet.

Zu der zweiten Klasse gehören 5-Nitroacenaphthene, 4-Nitroanilin, 2,4,7-Trinitro-9-flourenon, 3-Methyl-1,3-diaza-1,9-benzanthron und Bis(dialkylamino)benzophenone, besonders Michler's Keton, d.h. 4,4'-Bis(dimethylamino)-benzophenon.

Geeignete Trägermaterialien, auf welchen die flüssigen Stoffgemische erfindungsgemäss polymerisiert und vernetzt werden können, sind z.B. Metalle, besonders Kupfer und Aluminium, faserverstärkte Verbundwerkstoffe, die gegebenenfalls mit einem Metall überzogen sind, und Silicon-Wafer.

In der dritten Stufe des erfindungsgemässen Verfahrens wird vorzugsweise aktinisches Licht mit einer Wellenlänge von 200—600 nm eingesetzt. Geeignete Lichtquellen für aktinisches Licht sind z.B. Kohlelichtbögen, Quecksilberdampfbögen, fluoreszierende Lampen mit ultraviolettes Licht ausstrahlenden Phosphoren, Argon- und Xenonglühlampen, Wolframlampen und photographische Flutlichtlampen. Quecksilberdampflampen, besonders Sonneslampen, fluorenzierende Sonnenlampen und Metallhalogenidlampen sind besonders bevorzugt. Die für die Belichtung benötigte Zeit hängt von verschiedenen Faktoren ab, z.B. den spezifisch eingesetzten Verbindungen, dem Anteil dieser Verbindungen im Stoffgemisch, der Art der Lichtquelle und deren Abstand von dem Stoffgemisch. Die geeigneten Belichtungszeiten können von dem Fachmann auf dem Gebiet der Photovernetzung leicht ermittelt werden.

Nach der Bestrahlung werden die nicht belichteten Stellen mit Hilfe eines Lösungsmittels ausgewaschen, z.B. Cyclohexanon, 2-Aethoxyäthanol, Toluol, Aceton und Gemischen davon sowie wässrigen Säuren und Basen, wie verdünnte Salzsäure, wässriges Natriumcarbonat oder Natriumhydroxid. Die erfindungsgemässen Stoffgemische können somit zur Herstellung von Druckplatten und gedruckten Schaltungen verwendet werden. Die Verfahren zur Herstellung von Druckplatten und

gedruckten Schaltungen aus lichtvernetzbaren Stoffgemischen sind allgemein bekannt.

Die Erfindung wird in den folgenden Beispielen erläutert. Teile und Prozente sind Gewichtsteile bzw. Gewichtsprozente, sofern nichts anderes angegeben ist.

Die in den Beispielen verwendeten Harze werden wie folgt hergestellt:

Harz I

100 g 2,2-Bis(4-glycidyloxyphenyl)propan mit einem Epoxidgehalt von 5,1 Aequiv./kg und 0,1 g, 2,6-Di-tert-butyl-4-methylphenol werden zusammen gerührt und auf 100°C erhitzt. Das Gemisch wird im Verlaufe von $1\frac{1}{2}$ Stunden langsam mit einem Gemisch aus 19,1 g Acrylsäure, 0,05 g Chrom(III)tris-octanoat und 0,2 g 2,6-Di-tert-butyl-4-methylphenol versetzt. Nach Beendigung der Zugabe wird das Gemisch während weiteren 7 Stunden bei 100°C gerührt und abgekühlt. Das erhaltene Produkt hat einen vernachlässigbaren Epoxidgehalt.

Harz II

Es wird ein Gemisch aus 80% Phenol (20,84 Teile), 38,3% Formalinlösung (22,22 Teile) und 1,94 Teilen Zinkacetat hergestellt. Das Gemisch wird $2\frac{1}{2}$ Stunden unter Rückfluss erhitzt. Anschliessend wird die Lösung abgekühlt und die wässrige Phase wird entfernt, wobei 22,35 Teile eines phenolischen Resols erhalten werden. Dieses wird zuerst mit gesättigter NaOH-Lösung und dann zweimal mit Wasser gewaschen. Das erhaltene Resol hat eine Viskosität von 3,15 Pa s bei 25°C.

20 Teile dieses Resols werden mit 0,04 Teilen Tetramethylammoniumchlorid und 0,055 Teilen, 2,6-Di-tert-butyl-4-methylphenol vermischt und auf 80°C erhitzt. Im Verlaufe einer Stunde gibt man 7,37 Teile Glycidylmethacrylat zu. Nach beendeter Zugabe wird weitere $10\frac{3}{4}$ Stunden erhitzt. Das erhaltene Produkt, der 3-Methacryloyl-2-hydroxypropyläther eines phenolischen Resols, hat bei 25°C eine Viskosität von 14,75 Pa s und einen vernachlässigbaren Epoxidgehalt.

Harz III

100 g eines Epoxidharzes auf der Basis von 2,2-Bis-(4-hydroxyphenyl)propan mit einem Epoxidgehalt von 1,6 Aequivalenten/kg und 0,1 g 2,6-Di-tert-butyl-4-methylphenol werden bis zur Schmelze erhitzt, zusammen gerührt und auf 130°C erhitzt. Das erhaltene Gemisch wird im Verlaufe von 30 Minuten langsam mit einem Gemisch aus 10,7 g Acrylsäure, 0,05 g Chrom(III)tris-octanoat und 0,2 g 2,6-Di-tertbutyl-4-methylphenol versetzt. Nach beendeter Zugabe wird das Gemisch während weiterer 2 Stunden auf 130°C erhitzt und dann abgekühlt. Das erhaltene Produkt hat einen vernachlässigbaren Epoxidgehalt.

Harz IV

200 g 1,5-Bis(4-glycidyloxyphenyl)-1,4-pentadien-3-on, 76,4 g 2,2-Bis(3,5-dibrom-4-hydroxyphenyl)-propan, 54,6 g 2,2-Bis(4-hydroxyphenyl)propan, 0,1 g Tetraäthylammoniumbromid, 221 g 1,4-Butandioldimethyacrylat und 0,264 g 2,6-Di-tert.butyl-4-methylphenol werden gemischt und 24 Stunden auf 100°C erhitzt. Anschliessend werden 110 g 2-Hydroxyäthylmethacrylat zugegeben. Man erhält ein Gemisch mit 50% Feststoffgehalt, einem Epoxidgehalt von 1,12 Aequivalenten/kg (berechnet auf 100% Festharz) und einer Viskosität von 38,5 Pa s bei 25°C.

Beispiel 1

Eine gereinigte Kupferplatte wird mit einem sehr feinen Wasserstrahl so benetzt, dass auf der Oberfläche keine einzelnen Wassertröpfchen festgestellt werden können. Die Oberfläche wird mit einem Gemisch aus 10 Teilen Aethyl-2-cyanacrylat, 5 Teilen Harz I und 0,3 Teilen Benzildimethylketal beschichtet (Schichtdicke 20 µm). Nach 5 Minuten ist die Beschichtung klebefrei. Durch 2-minütiges Bestrahlen der Beschichtung durch ein Negativ mit einer 5000 W Mitteldruck-Quecksilberhalogenidlampe in einem Abstand von 75 cm und Entwickeln in einem 9:1-Volumengemisch aus Toluol und Aceton erhält man ein gutes Bild.

Beispiel 2

Man beschichtet ein gereinigtes kupferkaschiertes Laminat mit einer 25%igen äthanolischen p-Toluolsulfonsäure-Lösung und lässt die Beschichtung trocknen. Harz II wird mit 2% Benzildimethylketal vermischt. Mit der erhaltenen klaren Mischung beschichtet man das oben erwähnte vorbehandelte kupferkaschierte Laminat (Schichtdicke 20 µm) und hält es 16 Stunden bei Raumtemperatur. Dabei erhält man eine klebefreie Beschichtung. Die verfestigte Beschichtung wird während 1 Minute durch ein Negativ mit einer 5000 W Metallhalogenidlampe in einem Abstand von 75 cm bestrahlt. Nach dem Entwicklen mit 1,1,1-Trichloräthan bei 25°C während 2 Minuten erhält man ein gutes Bild.

Beispiel 3

Es wird ein Gemsich aus 10 Teilen Harz IV, 0,3 Teilen Cumolhydroperoxid und 0,025 Teilen o-Sulfobenzoesäureimid (Saccharin) hergestellt. Man beschichtet ein gereinigtes kupferkaschiertes Laminat mit Accelerator VN2® und lässt est trocknen. Des Accelerator VN2 ist ein im Handel erhältlicher Peroxid-Beschleuniger der Fa. Akzo Chemie U.K., Ltd., Wandsworth, London S.W. 18, der eine Lösung eines Uebergangsmetallsalzes in einem alkoholischen Lösungsmittel enthält. Das Laminat werd dann mit der

obigen Formulierung beschichtet. Man hält die Beschichtung 16 Stunden bei Raumtemperatur, wobei diese klebefrei wird. Die verfestigte Beschichtung wird während 2 Minuten durch ein Negativ mit einer 5000 W Metalhalogenidlampe in einem Abstand von 75 cm bestrahlt. Nach dem Entwickeln mit Cyclohexanon bei 25°C während einer Minute erhält man ein Bild.

Beispiel 4

10 Teile Harz I werden mit 4 Teilen eines Gemisches aus 2,4-Diisocyanatotoluol (80%) und 2,6-Diisocyanatotoluol (20%) und 0,1 Teil Benzildimethylketal vermischt. Man beschichtet ein vorgereinigtes kupferkaschiertes Laminat mit einer 30%igen Lösung von m-Phenylendiamin in Aceton und lässt es trocken. Das Laminat wird anschliessend mit der obigen Mischung beschichtet und während 8 Stunden bei Raumtemperatur in trockener Atmosphäre gehalten. Die verfestigte Beschichtung wird während 1 Minute durch ein Negativ mit einer 5000 W Metallhalogenidlampe in einem Abstand von 75 cm bestrahlt. Nach dem Entwickeln mit Toluol beim 25°C während 1 Minute erhält man ein gutes Bild.

Beispiel 5

Es wird ein Stoffgemisch aus 5 Teilen 2,2-Bis-(4-glycidyloxyphenyl)propan, 5 Teilen Phenylglycidyläther, 3,2 Teilen eines Gemisches aus aromatischen Diaminen, das ungefähr 50% 4,4'-Diaminodiphenylmethan und als Rest 3-Aethyl-4,4'-diaminodiphenylmethan und 3,3'-Diäthyl-4,4'-diaminodiphenylmethan enthält, 10 Teilen Harz I und 0,1 Teil Benzildimethylketal hergestellt. Mit dieser Formulierung wird eine gereinigte, mit einer 50%igen Lösung von Lanthannitrat-Hexahydrat in 2-Methoxyäthanol vorbehandelte Aluminiumplatte beschichtet. Die Beschichtung wird innerhalb von 30 Minuten klebefrei. Durch Bestrahlen während 1 Minute durch ein Negativ mit einer 5000 W Metallhalogenidlampe in einem Abstand von 75 cm und Entwickeln in einem 1:1-Volumengemisch aus Toluol und Aceton erhält man ein gutes Bild.

Beispiel 6

Beispiel 5 wird weiderholt, jedoch unter Verwendung einer Kupferplatte anstelle der Aluminiumplatte. Man erhält ein gutes Bild.

Beispiel 7

Man behandelt eine Epoxidharz/Glasfaser-Laminatplatte mit einer Lösung von Eisen-Naphthenat in Ligroin (Polymerisationsmittel; Fe-Gehalt 6%) und lässt sie trocknen. Die Platte wird dann mit einem 10 Teile Harz II, 0,3 Teile Cumolhydroperoxid, 0,025 Teile o-Sulfonbenzoesäureimid und 0,5 Teile Phenyl(2,6-dimethyl-4-oxo-4H-pyran-3-yl)jodoniumtosylat [hergestellt aus äquimolaren Mengen 2,6-Dimethyl-γ-pyron und Phenyljodosotosylat durch Vermischen in Chloroform bei Raumptemperatur und Ausfällen des Produkts mit überschüssigem Petroläther] enthaltenden Gemisch beschichtet. Die Beschichtung verfestigt sich bei Raumtemperatur innerhalb von 24 Stunden. Sie wird anschliessend während 5 Minuten durch ein Negativ mit einer 5000 W Metallhalogenidlampe in einem Abstand von 75 cm bestrahlt. Nach dem Entwickeln in einem 9:1-Volumengemisch aus Toluol and Aceton erhält man ein Bild.

Beispiel 8

Man behandelt eine Epoxidharz/Glasfaser-Laminatplatte mit einer Lösung von Eisen-Naphthenat (= Polymerisationsmittel) in Lackbenzin (Testbenzin, Fe-Gehalt 6%) und lässt sie trocknen. Dann wird die Platte mit einem Gemisch aus 30 Teilen 3,4-Epoxycyclohexylmethyl-3',4'-epoxycyclohexan-carboxylat mit einem Epoxidgehalt von 7,3 Aequivalenten/kg, 30 Teilen 2,2-Bis(4-glycidyloxyphenyl)propan mit einem Epoxidgehalt von 5,1 Aequivalenten/kg, 30 Teilen Harz I, 10 Teilen Trimethylolpropan-trismethacrylat, 3 Teilen Cumolhydroperoxid und 5 Teilen Diphenyljodonium-Hexafluorphosphat beschichtet. Man lässt die Platte währen 2 Stunden bei 30°C trocknen, wobei ein klebefreier Film entsteht. Die verfestigte Beschichtung wird während 5 Minuten durch ein Negativ mit einer 5000 W Metallhalogenidlampe in einem Abstand von 75 cm bestrahlt. Nach dem Entwicklen mit Aethanol bei 25°C während 1 Minute erhält man ein Bild.

Beispiel 9

Eine Lösung von Bordifluorid-2-hydroxyacetophenonchelat in Aceton wird durch Bürsten auf ein kupferkaschiertes Laminat aufgetragen und bei Raumtemperatur getrocknet. Dann wird mit dem folgenden Gemisch eine 30 Mikrometer dicke Beschichtung appliziert: 20 Teile Harz III, 15 Teile Butandioldiglycidyläther, 5 Teile n-Butylglycidyläther, 1,2 Teile Benzildimethylketal. Nach einer Stunde bei Raumtemperatur ist die Beschichtung klebefrei. Die verfestigte Beschichtung wird während 2 Minuten durch ein Negativ mit einer 5000 W Metallhalogenidlampe in einem Abstand von 75 cm bestrahlt. Durch Entwickeln mit Cyclohexan erhält man ein Bild.

Die in diesem Beispiel als Polymerisationsmittel verwendete Chelat-Lösung wird wie folgt hergestellt; 100 g Bortrifluoriddiäthyläther-Komplex in 250 ml Toluol werden langsam erhitzt, bis die Destillation beginnt. Unter Aufrechterhalten der Destillation werden im Verlaufe einer Stunde 98 g 2-Hydroxyacetophenon zugetropft. Die Destillation wird weitergeführt, bis kein Wasserstoff-Fluorid mehr entsteht. Anschliessend wird die Lösung abgekühlt, und die erhaltenen Chelat-Kristalle werden abfiltriert. Das Chelat wird bei Raumtemperatur in der Mindestmenge Aceton gelöst.

Beispiel 10

Eine Lösung von N,N'''-Bis(1-(2-butyl)äthyliden)3,6-diaza-octan-1,8-diamin in Methylisobutylketon wird durch Bürsten auf ein kupferkaschiertes Laminat aufgetragen und bei Raumtemperatur getrocknet. Dann wird mit dem folgenden Gemisch eine 50 Mikrometer dicke Beschichtung appliziert: 20 Teile Harz III, 5 Teile Trimethylolpropan-trismethlyacrylat, 5 Teile 2-Hydroxyäthylmethacrylat, 0,9 Teile Benzildimethylketal und 0,9 Teile Cumolhydroperoxid. Nach dem Stehenlassen über Nacht bei Raumtemperatur ist die Beschichtung klebefrei. Die verfestigte Schicht wird während 2 Minuten durch ein Negativ mit einer 5000 W Metallhalogenidlampe in einer Abstand von 75 cm bestrahlt. Nach dem Entwickeln mit einem 70:30-Volumengemisch aus Toluol und Aceton erhält man ein Bild.

Die in diesem Beispiel als Polymerisationsmittel verwendete Lösung der Schiff-Base wird wie folgt hergestellt: 14,6 g 3,6-Diazaoctan-1,8-diamin und 40,0 g Methylisobutylketon in 250 ml Toluol werden unter Rückflüss unter einer Dean-Stark-Falle so lange erhitzt, bis sich die erforderliche Menge Wasser (3,6 ml) abgeschieden hat. Anschliessend wird das Toluol durch Destillation entfernt.

## Patentansprüche

1. Verfahren zu Bilderzeugung, wobei eine verfestigte, lichtvernetzbare Schicht durch ein durch ein vorgegebenes Muster derart mit aktinischem Licht bestrahlt wird, dass die bestrahlten Teile der Schicht vernetzt werden und die Teile der Schicht, welche unter der Einwirkung von Licht im wesentlichen nicht vernetzt wurden, durch Behandlung mit einem dafür geeigetnen Lösungsmittel entfernt werden, dadurch gekennzeichnet, dass man die verfestigte, lichtvernetzbare Schicht herstellt, indem man

a) auf ein Substrat ein Polymerisationsmittel aufträgt, und

b) auf das Polymerisationsmittel auf dem Substrat eine Schicht aus einem flüssigen Stoffgemisch, das einem im Kontakt mit dem Polymerisationsmittel polymerisierbaren und einen lichtvernetzbaren Rest enthält, derart appliziert, dass die Schicht sich verfestigt, aber noch lichtvernetzbar bleibt.

2. Verfahren nach Anspruch 1, worin das flüssige Stoffgemisch eine Substanz enthält, welche die polymerisierbare und die lichtvernetzbare Gruppe in demselben Molekül aufweist.

3. Verfahren nach Anspruch 1, worin das flüssige Stoffgemisch ein Gemisch aus einem oder mehreren im Kontakt mit dem Polymerisationsmittel polymerisierbaren Materialien und einem oder mehreren lichtvernetzbaren Materialien enthält.

4. Verfahren nach einem der vorhergehenden Ansprüche, worin der polymerisierbare Rest eine einzige Spezies oder zwei oder mehrere ähnliche Spezies, die unter der katalytischen Einwirkung des Polymerisationsmittels polymerisieren, oder zwei oder mehrere miteinander reagierende Spezies enthält, die vergleichsweise stabil sind, bis deren Reaktion untereinander durch das Polymerisationsmittel katalysiert oder beschleunigt wird.

5. Verfahren nach Anspruch 4, worin die polymerisierbaren Reste und deren Polymerisationsmittel eines der folgenden sind: Cyanacrylate mit Wasser, wässriger Ammoniumhydroxidlösung, einer wässrigen Alkalimetallhydroxidlösung oder einem Amin; Gemische aus Polyolen und Isocyanaten mit wässriger Ammoniumhydroxidlösung, einer wässrigen Alkalimetallhydroxidlösung oder einem Amin; Isocyanat-Endgruppen aufweisende Präpolymere mit Wasser, wässriger Ammoniumhydroxidlösung, einer wässrigen Alkalimetalhydroxidlösung oder einem Amin; Polyen-Polythiol-Gemische mit wässriger Ammoniumhydroxidlösung, einer wässrigen Alkalimetallhydroxidlösung oder einem Amin; Epoxidharze mit einem Bortrifluorid- oder Bortrichlorid-Komplex, einem Bordifluorid-Chelat, Dicyandiamid, einem Imidazol, einem Amin oder einem Säureanhydrid; Epoxidharz/Amind-Gemische mit einer Säure, einer wässrigen sauren Lösung, einer Lösung eines sauren Salzes oder mit einem als Beschleuniger für Epoxidharz/Amin-Reaktionen bekannten Metallperchlorat, Trifluormethansulfonat, Trihalogencarboxylat oder Nitrat; Epoxidharz/Thiol-Gemische mit wässriger Ammoniumhydroxidlösung oder einem Amin; phenolische Harze mit einer Säure oder einer wässrigen sauren Lösung; sowie Gemische aus einem Acrylat oder Methacrylat und einem Peroxid-Initiator zusammen mit einem Beschleuniger für das Peroxid, ausgewählt aus Aminen, Schiff-Basen, Uebergangsmetallen oder Salzen davon.

6. Verfahren nach Anspruch 5, worin der polymerisierbare Rest

i) ein Cyanacrylat der Formel I

$$H_2C=\underset{\displaystyle CN}{\underset{|}{C}}-COOR^1 \qquad (I),$$

worin $R^1$ eine Alkyl-, Alkenyl-, Aralkyl-, Halogenalkyl-, Cycloalkyl, Aryl- oder Alkoxyalkylgruppe mit höchstens 18 C-Atomen bedeutet,

ii) ein Isocyanatendgruppen aufweisenden Präpolymer, erhalten durch Umsetzung eines Polyols, Polyamins oder einer Polycarbonsäure mit einem aliphatischen, cycloaliphatischen oder aromatischen Diisocyanat,

iii) ein Epoxidharz mit mindestens zwei direkt an Sauerstoff-, Stickstoff- oder Schwefelatome gebundenen Gruppen der Formel II

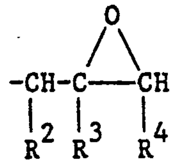

(II)

worin $R^2$ und $R^4$ ein Wasserstoffatom und $R^3$ ein Wasserstoffatom oder eine Methylgruppe oder $R^2$ und $R^4$ zusammen $—CH_2CH_2—$ und $R^3$ ein Wasserstoffatom darstellen,

iv) ein Epoxidharz, in dem einige oder alle Epoxidgruppen nicht endständig sind oder

v) ein phenolisches Harz aus einem Phenol und einem Aldehyd ist.

7. Verfahren nach Anspruch 5, worin der polymerisierbare Rest

i) eine Gemisch aus einem Alkylenglykol, einem Polyoxyalkylenglykol, einem Alkantriol, einem hydroxylgruppenhaltigen Reaktionsprodukt aus einem Epoxidharz und einer Carbonsäure, einem Carbonsäureanhydrid, einem Phenol, einem primären oder sekundären Amin oder einem Thiol, Pentaerythrit oder einem hydroxylgruppenhaltigen Polymer mit einem aliphatischen, cycloaliphatischen oder aromatischen Isocyanat,

ii) eine Gemisch aus einem Polyen mit einem Molekulargewicht von 50—20000, das zwei oder mehr äthylenische oder äthynylische, zur Polymerisation in Gegenwart von freien Radikalbildnern befähigte Bindungen aufweist, oder aus einem Epoxidharz gemäss Anspruch 6 und einem Polythiol mit einem Molekulargewicht von 50—20000, wobei das Polythiol ein Ester der Thioglykolsäure, α-Mercaptopropionsäure oder β-Mercaptopropionsäure mit einem Glykol, einem Triol, Tetraol, Pentaol oder Hexol ist,

iii) ein Gemisch aus einem Epoxidharz gemäss Anspruch 6 und einem aliphatischen, alicyclischen, ungesättigten heterocyclischen, aromatischen oder araliphatischen, primären, sekundären oder tertiären Amin, oder

iv) ein Gemisch aus einem Acrylat- oder Methacrylatmonomer, ausgewählt aus Acrylsäure, Methacrylsäure, Alkylacrylaten, Alkylendioldiacrylaten, 1,1,1-Trimethylolpropantriacrylat, Polypropylenglykoldiacrylaten, Allylacrylat, Acrylatestern von Epoxiden oder phenolischen Resolen, oder einem entsprechenden Methacrylat, und Wasserstoffperoxid, tert-Butylhydroperoxid, Cumolhydroperoxid oder 2,4-Dimethyl-2,4-hexandihydroperoxid ist.

8. Verfahren nach einem der vorhergehenden Ansprüche, worin die vorhandenen lichtvernetzbaren Reste solche sind, die durch direkte Aktivierung einer lichtempfindlichen Gruppe mittels Bestrahlung vernetzt werden, und worin das lichtempfindliche Material mindestens zwei Azido-, Cumarin-, Stilben-, Maleindimid-, Pyridinon-, Chalkon-, Propenon-, Pentadienon- oder Anthracengruppen oder Acrylestergruppen aufweist, wobei die Acrylestergruppen in 3-Stellung durch eine äthylenisch ungesättigte Gruppe oder eine aromatische Gruppe in Konjugation mit der äthylenischen Doppelbindung der Acrylgruppe substituiert ist.

9. Verfahren nach Anspruch 1, worin die vorhandenen lichtvernetzbaren Reste solche sind, worin durch die Bestrahlung ein geeignetes Initiatormolekül aktiviert wird, das dann eine lichtvernetzbare Gruppe aktiviert, und worin der lichtvernetzbare Rest ein Epoxidharz, ein phenolisches Harz, ein Harnstoff-Formaldehyd-Harz, ein cyclischer Aether, ein cyclischer Ester, ein cyclisches Sulfid, ein cyclisches Amin oder eine cyclische Organosiliziumverbindung in Kombination mit einem strahlungsempfindlichen aromatischen Onium- oder Jodosylsalz, ein Ester oder Teilester der Acrylsäure oder Methacrylsäure mit einem aliphatischen einwertigen Alkohol, einem Glykol oder einem höherwertigen Polyol oder mit einer Verbindung mit einer oder mehr Glycidylgruppen, oder ein Ester, erhalten durch Reaktion eines Polyepoxids mit einem Addukt eines Hydroxyalkylacrylats oder -methacrylate mit einem gesättigten oder ungesättigten Polycarbonsäureanhydrid ist.

10. Verfahren nach Anspruch 2, worin die Substanz mit polymerisierbaren und lichtvernetzbaren Gruppen in demselben Molekül ein Epoxidharz oder phenolisches Resol mit einer lichtvernetzbaren Gruppe oder, zusammen mit einem Isocyanat, eine Hydroxyverbindung mit einer lichtvernetzbaren Gruppe ist.

11. Verfahren nach einem der vorhergehenden Ansprüche, worin das Polymerisationsmittel durch Sprühen, Tauchen, Bürsten oder Schleuderbeschichtung appliziert wird, wobei — sofern das Polymerisationsmittel nicht flüssig ist — die Applikation aus einer Lösung oder Suspension in Wasser oder einem organischen Lösungsmittel erfolgt.

**Revendications**

1. Procédé de production d'images, selon lequel on soumet une couche photoréticulable et solidifiée à une exposition à de la luminère actinique à travers un dessin donné, de manière que les endroits de la couche touchée par la luminère se réticulent et l'on enlève, par traitement à l'aide d'un solvant convenant à cet effet, les endroits de la couche qui n'ont pas été nettement réticulés sous l'influence de la lumière, procédé caracterisé en ce qu'on produit la couche photoréticulable durcie:

a) en appliquant sur un substrat un agent de polymérisation, et

b) en appliquant sur l'agent de polymérisation sur le substrat une couche d'un mélange liquide de substances contenant un reste polymérisable par contact avec l'agent de polymerisation et un reste photoréticulable, l'application étant réalisée de manière que la couche se solidifie mais ne soit par encore photoréticulable.

2. Procédé selon la revendication 1, dans lequel le mélange liquide des substances contient une substance qui présente dans la même molécule le groupe polymérisable et le groupe photoréticulable.

3. Procédé selon la revendication 1, dans lequel le mélange liquide des substances contient un mélange d'une ou plusieurs matières pouvant polymériser au contact de l'agent de polymérisations et une ou plusieurs matières photoréticulables.

4. Procédé selon l'une des revendications précédentes, dans lequel le reste polymérisable contient une seule espèce ou bien deux ou plusieurs espèces analogues qui, sous l'action, catalytique de l'agent de polymérisation, polymérisent, ou bien il contient deux ou plusieurs espèces pouvant mutuellement réagir, et qui sont relativement stables, jusqu'à ce que leur réaction mutuelle soit catalysée ou accélérée par l'agent de polyméristion.

5. Procédé selon la revendication 4, dans lequel les restes polymérisable et leur agent de polymérisation sont l'un des siuvants: des cyanacrylates avec de l'eau, une solution aqueuse d'hydroxyde d'ammonium, une solution aqueuse d'un hydroxyde de métal alcalin ou d'une amine; des mélanges de polyols et d'isocyanates avec une solution aqueuse d'hydroxyde d'ammonium, une solution aqueuse d'un hydroxyde de métal alcalin ou d'une amine; des prépolymères présentant des groupes isocyanates terminaux avec de l'eau, avec une solution aqueuse d'hydroxyde d'ammonium, avec une solution aqueuse d'un hydroxyde de métal alcalin ou d'une amine; des mélanges polyène-polythiol avec une solution aqueuse d'hydroxyde d'ammonium, une solution aqueuse d'un hydroxyde de métal alcalin ou d'une amine; des résines époxydes avec un complexe de trifluorure de bore au de trichlorure de bore, un chélate de difluorure de bore, du dicyanodiamide, un imidazole, une amine ou un anhydride d'acide; des mélanges résine époxyde/amine avec un acide, une solution aqueuse d'acide, une solution d'un sel acide ou d'un perchlorate de métal, d'un trifluorométhane sulfonate, d'un trihalogénocarboxylate ou d'un nitrate connu comme accélérateur pour des réactions résine époxyde/amine; des mélanges résine époxyde/thiol avec une solution aqueuse d'hydroxyde d'ammonium ou d'une amine; des résines phénoliques avec un acide ou une solution aqueuse acide; ainsi que des mélanges d'un acrylate ou méthacrylate et d'un amorceur peroxydique avec un accélérateur pour le peroxyde, choisi parmi des amines, des bases de Schiff, des métaux de transition ou leurs sels.

6. Procédé selon la revendication 5, dans lequel le reste polymérisable est:

i) un cyanacrylate de formule I:

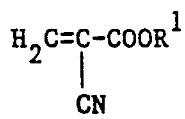

(I),

dans laquelle $R^1$ représente un groupe alkyle, alcényle, aralkyle, halogéno-alkyle, cycloalkyle, aryle ou alcoxyalkyle ayant au maximum 18 atomes de carbone,

ii) une prépolymère présentant des groupes isocyanates terminaux, que l'on obtient par réaction d'un polyol, d'une polyamine ou d'un acide polycarboxylique avec un diisocyanate aliphatique, cycloaliphatique ou aromatique.

iii) une résine époxyde comportant au moins deux groupes, reliés directement à l'atome d'oxygène, d'azote ou de soufre, de formule II:

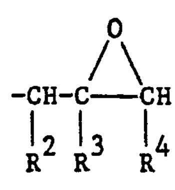

(II)

dans laquelle $R^2$ et $R^4$ représentent chacun un atome d'hydrogène et $R^3$ est un atome d'hydrogène ou un groupe méthyle, ou bien $R^2$ et $R^4$ forment ensemble $—CH_2CH_2—$ et $R^3$ représente un atome d'hydrogène,

iv) une résine époxyde, dans laquelle certains ou tous les groupes époxydes ne sont pas en position terminale; ou

v) une résine phénolique obtenue à partir d'un phénol et d'un aldéhyde.

7. Procédé selon la revendication 5, dans lequel le reste polymérisable est:

i) un mélange d'un alkylène-glycol, d'un polyoxyéthylène-glycol, d'un alcanetriol, d'un produit, contenant des groupes hydroxyles, de réaction d'une résine époxyde et d'un acide carboxylique, un anhydride d'acide carboxylique, un phénol, une amine primaire ou secondaire ou un thiol, du

pentaérythritol ou un polymère, contenant des groupes hydroxyles, d'une part, avec un isocyanate aliphatique, cycloaliphatique ou aromatique, d'autre part,

ii) un mélange d'un polyène ayant un poids moléculaire de 50 à 20 000, qui présente deux ou plusieurs liaisons éthyléniques ou éthynyliques capables d'un polymérisation en présence de générateur de radicaux libres, ou un mélange d'une résine époxyde selon la revendication 6 et d'un polythiol ayant un poids moléculaire de 50 à 20 000, le polythiol étant un ester de l'acide thioglycolique, de l'acide alpha-mercaptopropionique ou de l'acide bêta-merceptapropionique avec un glycol, un triol, un tétrol, un pentol ou un hexol,

iii) un mélange d'une résine époxyde selon la revendication 6 et d'une amine aliphatique, alicyclique, hétérocyclique insaturée, aromatique ou araliphatique, primaire, secondaire ou tertiaire, ou

iv) un mélange d'un monomère acrylique ou méthacrilique, choisi parmi l'acide acrylique, l'acide méthacrylique, des acrylates d'alkyle, des diacrylates d'alkylènediols, le triacrylate de triméthylol-1,1,1 propane, des diacrylates de polypropylène-glycols, l'acrylate d'allyle, des esters acryliques d'époxydes ou de résols phénoliques, ou un méthacrylate correspondant, et de peroxydes d'hydrogène, d'hydroperoxyde de tertiobutyle, d'hydroperoxyde de cumène ou de dihydroperoxyde de diméthyl-2,4 hexane-2,6.

8. Procédé selon l'une des revendications précédentes, dans lequel les restes photoréticulables présents sont ceux qui sont réticulés par activation directe, à l'aide d'une exposition, d'un groupe photosensible, et dans lequel la matière photosensible présente au moins deux groupes azido, coumarine, stilbène, maléinimide, pyridinone, chalcone, propénone, pentadiénone ou anthracène ou des groupes esters acryliques, le groupe ester acrylique étant fixé comme substituant en position 3 par l'intermédiaire d'un groupe à insaturation éthylénique ou d'un groupe aromatique en conjugaison avec la double liaison éthylénique du groupe acrylique.

9. Procédé selon la revendication 1, dans lequel les restes photoréticulable présents sont tels qu'une molécule d'amorceur convenable est activée par l'exposition à un rayonnement, et active ensuite un groupe photoréticulable, et le reste photoréticulable est une résine époxyde, une résine phénolique, une résine urée-formaldéhyde, un éther cyclique, un ester cyclique, un sulfure cyclique, une amine cyclique ou un composé d'organosilicium cyclique en combinasion avec un sel d'onium aromatique sensible à un raynnement ou avec un sel d'iodosyle, un ester ou ester partiel de l'acide acrylique ou de l'acide méthacrylique avec un alcool monovalent aliphatique, un glycol ou un polyol à plus grande valence ou avec un composé comportant un ou plusiers groupes glycidyles, ou un ester, obtenu par réaction d'un polyépoxyde avec un produit d'addition d'un acrylate ou méthacrylate d'hydroxyalkyle avec un anhydride d'acide polycarboxylique saturé ou insaturé.

10. Procédé selon la revendication 2, dans lequel la substance comportant des groupes polymérisables et des groupes photoréticulables dans la même molécule est une résiné époxyde ou un résol phénolique comportant un groupe photoréticulable ou bien elle est, avec un isocyanate, une composé hydroxylé comportant un groupe photoréticulable.

11. Procédé selon l'une des revendications précédentes, dans lequel l'agent de polymérisation est appliqué par projection de pulvérisation, immersion, application un pinceau ou à la brosse ou revêtement centrifuge et, dans le mesure où l'agent de polymérisation n'est pas liquide, l'application a lieu à partir d'un solution ou suspension dans de l'eau ou dans un solvant organique.

**Claims**

1. A process for the production of an image, where a solidified photocrosslinkable layer is irradiated with actinic radiation through a predetermined pattern such that the irradiated parts of the layer are crosslinked and the parts of the layer which were not substantially crosslinked under the action of radiation are removed by treatment with a solvent suitable therefor, which process comprises producing the solidified photocrosslinkable layer by

a) applying to a substrate a polymerizing agent, and

b) applying to the polymerizing agent on the substrate a layer of a liquid composition containing a radical that is polymerizable on contact with the polymerizing agent, and a photocrosslinkable radical, such that the layer solidifies but remains photocrosslinkable.

2. A process according to claim 1, in which the liquid composition contains a substance having the polymerizable group and the photocrosslinkable group in the same molecule.

3. A process according to claim 1, in which the liquid composition contains a mixture of one or more materials that are polymerizable on contact with the polymerizing agent, and one or more photocrosslinkable materials.

4. A process according to claims 1—3, in which the polymerizable radical comprises a single species or two or more similar species which polymerize under the catalytic action of the polymerizing agent, or two or more co-reacting species which are comparatively stable until their reactions with one another is catalysed or accelerated by the polymerizing agent.

5. A process according to claim 4, in which the polymerizable radical and its polymerizing agent are one of the following: a cyanoacrylate with water, aqueous ammonium hydroxide solution, an aqueous alkali metal hydroxide solution or an amine; mixtures of polyols and isocyanates with aqueous ammonium

hydroxide solution, an aqueous alkali metal hydroxide solution or an amine; prepolymers having isocyanate end grops with water, aqueous ammonium hydroxide solution, an aqueous alkali metal hydroxide solution or an amine; polyene/polythiol mixtures with aqueous ammonium hydroxide solution, an aqueous alkali metal hydroxide solution or an amine; epoxy resins with a borontrifluoride or borontrichloride complex, a borondifluoride chelate, dicyandiamide, an imidazole, an amine or anhydride; epoxy resin/amine mixtures with an acid, an aqueous acid solution, a solution of an acid salt or with a metal perchlorate, trifluoromethane sulfonate, trihalocarboxylate or nitrate known as an accelerator for epoxy resin/amine reactions; epoxy resin/thiol mixtures with aqueous ammonium hydroxide solution or an amine; phenolic resins with an acid or an aqueous acid solution; and also mixtures of an acrylate or methacrylate and a peroxide initiator together with an accelerator for the peroxide, selected from amines, Schiff's bases, transition metals or salts thereof.

6. A process according to claim 5, in which the polymerizable radical is

i) a cyanoacrylate of the formula I

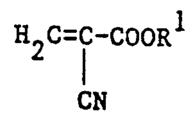

(I),

in which $R^1$ is an alkyl, alkenyl, aralkyl, haloalkyl, cycloalkyl, aryl or alkoxyalkyl group, having at most 18 carbon atoms,

ii) a prepolymer having isocyanate end groups and obtained by reaction of a polyol, polyamine, or a polycarboxylic acid with an aliphatic, cycloaliphatic or aromatic disocyanate,

iii) an epoxy resin at least two groups of the formula II

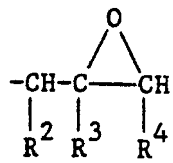

(II)

directly attached to oxygen, nitrogen or sulfur atoms, in which formula $R^2$ and $R^4$ are each a hydrogen atom and $R^3$ is a hydrogen atom or a methyl group, or $R^2$ and $R^4$ together are $—CH_2CH_2—$ and $R^3$ is a hydrogen atom,

iv) an epoxy resin in which some or all of the epoxide groups are not in terminal positions, or

v) a phenolic resin made from a phenol and an aldehyde.

7. A process according to claim 5, in which the polymerizable radical is

i) a mixture of an alkylene glycol, a polyoxyalkylene glycol, an alkane triol, a hydroxyl group-containing reaction product of an epoxy resin with a carboxylic acid, a carboxylic anhydride, a phenol, a primary or secondary amine, or a thiol, pentaerythritol, or a hydroxyl group-containing polymer with an aliphatic, cycloaliphatic or aromatic isocyanate,

ii) a mixture of a polyene having a molecular weight of 50 to 20,000 and containing two or more ethylenic or ethynylic bonds capable of polyermization in the presence of free-radical formers, or of an epoxy resin according to claim 6 with a polythiol having a molecular weight of 50 to 20,000, the polythiol being an ester of thioglycolic acid, α-mercaptopropionic acid or β-mercaptopropionic acid with glycol, a triol, tetraol, pentaol or hexol,

iii) a mixture of an epoxy resin according to claim 6 with an aliphatic, alicyclic, unsaturated heterocyclic, aromatic, or araliphatic primary, secondary or tertiary amine, or

iv) a mixture of an acrylate or methacrylate monomer selected from acrylic acid or methacrylic acid, or an alkyl acrylate, alkylenediol diacrylate, 1,1,1-trimethylolpropane triacrylate, polypropylene glycol diacrylate, allyl acrylate, acrylate esters of epoxides or phenolic resols, or a corresponding methacrylate, with hydrogen peroxide, tert-butyl hydroperoxide, cumene hydroperoxide or 2,4-dimethyl-2,4-hexane dihydroperoxide.

8. A process according to any one of the preceding claims, in which the photocrosslinkable radical present is one which is crosslinked by direct activation of a photosensitive group through irradiation, and in which the photosensitive has at least two azido, coumarin, stilbene, maleimide, pyridinone, chalcone, propenone, pentadienone, or anthracene groups or acrylic ester groups, the acrylic ester groups being substituted in the 3-position by an ethylenically unsaturated group or an aromatic group in conjugation with the ethylenic double bond of the acrylic group.

9. A process according to claim 1, in which the photocrosslinkable radical present is one in which irradiation activates a suitable initiator molecule which then activates a photocrosslinkable group, and in

which the photocrosslinkable radical is an epoxy resin, a phenolic resin, a urea-formaldehyde resin, a cyclic ether, a cyclic ester, a cyclic sulfide, a cyclic amine or a cyclic organosilicon compound in combination with a radiation-sensitive aromatic onium or iodosyl salt, an ester or partial ester of acrylic acid or methacrylic acid with an aliphatic monohydric alcohol, a glycol, or a higher functional polyol or with a compound having one or more glycidyl groups, or an ester obtained by reaction of polyepoxide with an adduct of a hydroxyalkyl acrylate or methacrylate with a saturated or unsaturated polycarboxylic acid anhydride.

10. A process according to claim 2, in which the substance having polymerizable and photocrosslinkable groups in the same molecule is an epoxy resin or phenolic resol having a photocrosslinkable group, or, together with an isocyanate, is a hydroxy compound having a photocrosslinkable group.

11. A process according to any one of the preceding claims, in which the polymerizing agent is applied by spraying, dipping, brushing or spin-coating, the application being carried out from a solution or suspension in water or an organic solvent where the polymerizing agent is not a liquid.